Europäisches Patentamt

European Patent Office

Office européen des brevets

(11) Publication number: **0 448 910 A1**

## EUROPEAN PATENT APPLICATION

(21) Application number: 90810250.2

(51) Int. Cl.⁵: **G01R 21/00**, G01R 21/133

(22) Date of filing: 28.03.90

(43) Date of publication of application:
**02.10.91 Bulletin 91/40**

(84) Designated Contracting States:
**AT BE CH DE DK ES FR GB GR IT LI LU NL SE**

(71) Applicant: WEG ENERGY (OVERSEAS) LTD.
P.O. Box 2356
Yavne(IL)

(72) Inventor: Reeve, Bryan, R.
49 Milton Avenue
Rustington, W. Sussex(GB)

(74) Representative: Werner, Guy et al
Bugnion S.A. Case postale 375 10 Route de
Florissant
CH-1211 Genève 12 - Champel(CH)

(54) Metering management system responsive to supplied wave form and including a secure metering apparatus.

(57) A secure metering apparatus comprising:
(a) a closed box having at least a pair of passages therethrough adapted to receive the conductors for customer electrical power distribution therethrough, said box fitting about the conductors, and said box incorporating enclosure means therewith;
(b) electric current measuring means connected with said conductors for measuring current flow thereacross;
(c) electric voltage measuring means connected with said conductors for measuring voltage therethrough substantially without intrusion into said conductors;
(d) power measuring means connected to said current measuring means and voltage measuring means for forming an output signal indicative of measured power consumption; and
(e) two way transmission means connected with said power measuring means for forming secure communications to and from said power measuring means for forming a remote secure indication of power consumed by the customer.

EP 0 448 910 A1

## BACKGROUND OF THE INVENTION

The present apparatus is a mounted meter typically installed on a multi-phase electrical installation for metering electrical power. It responds to typical three-phase distribution system including a neutral wire, and measures electrical power consumption with a high degree of accuracy. Moreover, it can be loaded with individualized tariffs to cover such vagaries as peak loading, excessive conductive loading creating an excessively large power factor (PF) and can also calculate and respond to kilowatt hours (KWH) or alternatively, can respond to reactive load typically indicated in VARs. The system further incorporates a clock which permits loading of variable tariffs as a function of time of day, day of week, etc. so that cost of utility consumption can be correlated to the tariff imposed for that particular type of class of customer. The apparatus is especially simpler to install than the typical Ferraris wheel kwh meter which requires breaking into the customer distribution lines. It is therefore an apparatus having no moving parts and is a solid state system which can operate in all types of inclement weather, e.g., between -20° up to 70°C. It would appear to have much greater life than the well known mechanical system, typically 25 year, MTBF. Moreover, it is a secure system of a single unit of substantially integral construction enclosed within a cabinet or case having a specified data storage capacity which is connected to the power distributing conductors in a safe and isolated fashion. It thus is a relatively small structure which is more readily mounted. Ideally, the present apparatus cooperates with an input system utilizing one of the multi-phase distribution lines by means of a data link from a remotely located interrogation CPU which provides appropriate timed inputs and which retrieves data so that billing costs and the like can be calculated. A data link places data on the distribution lines which are obviously separated in frequency from the power placed on the lines. The data link couples this data communication information onto and off of the system so that the present apparatus can communicate up through the system with a return response. A phase lock loop (PLL) is incorporated to aid and assist in measuring the line voltage. Accordingly, the input signal can be a pure sinusoidal signal, or it can be loaded with unwanted harmonics, but the system will nevertheless determine the RMS value of the input voltage. The same is true of the current flow. That is, the current flow in a particular phase is detected by current transformer system converted into a voltage cross reference resistor, and the shape of that wave can likewise be determined. Accuracy in the measurements of voltage and currents leads to an accurate measurement of VARs and KWH. The phase angle (PF) is likewise periodically determined so that the power consumption can be properly calculated.

The apparatus can have one or more KWH registers. If only one, all power is thus charged at the same price; however, alternate registers can be used so that different registers are incorporated for different tariffs as for example for peak loading when large machinery is switched on in an industrial plant.

The present apparatus is designed for long life without replacement. It is desirable to provide a mean time before failure (MTBF) of great life, or 25 years. To this end, the system uses excessive memory. It includes a routine as will be described below wherein data is written into memory, and is then checked. After checking, if the data is correct, that portion of memory can be used. On the other hand, after writing the memory checked may indicate a failure of data written into memory. If this occurs at a particular memory location a specified number of intervals, the data is simply written elsewhere in the memory and that portion of memory is not used. Because of the availability of excessive memory, portions of the memory can fail without reducing the MTBF.

This system digitizes multiplexed variables, one, two or more being flowmeter measurements. The installation location can be monitored for measured water or gas consumption. This is usually done by installing a flowmeter to form a time dependent signal indicative of flow rate in gallons/minute or perhaps cubic feet per hour. This system therefore simultaneously converts other utility consumption variables into total volume or cost of utilities. Moreover, the meter reading function can be handled in the same manner and in the same data transfer as the electrical power data. The calculation to determine three phase power (both KWH and VAR) is relatively complex compared to flowmeter (water or gas) consumption. Flowmeter date is dynamically integrated over time for selected intervals, i.e., one billing cycle, or perhaps a peak load period of 15 minutes. In any case, the present CPU based system is able to handle this less complex computation, and store the interim and billing cycle data. Moreover, a secure data link interrogation (at the end of a billing cycle) can read all utility costs of a customer, namely water and gas along with electrical consumption.

These and many other features are incorporated in the system which is described in detail below. The present system is best understood on review of the drawings which are incorporated in conjunction with the description of the preferred embodiment.

## BRIEF DESCRIPTION OF THE DRAWINGS

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

In the Drawings

Fig. 1 is a schematic block diagram showing a power distribution system and illustrating the location of the meter of the present disclosure to permit data communication to the power distribution system and to a central computer installation;

Fig. 2 is a front view of the meter mounting block of Fig. 1 on a three-phase, four-wire system showing current transformers and conductor clamps which measure voltage and current in the distribution system together with input of water and gas flow signals and further illustrating an integrally installed and secure mounting;

Fig. 3 is a schematic block diagram of the electronic apparatus incorporated in the meter mounting block which is mechanically illustrated in Fig. 2 of the drawings;

Fig. 4 is a schematic block diagram of an alternate form of a sinusoidal wave form digitizing apparatus featuring a phase lock loop driven comparator system;

Fig. 5 is a flow chart of a reset routine for preparing the system for operation;

Fig. 6 is an execution routine which continues from the sequence of Fig. 5; and

Fig. 7 is a calculation routine for utility cost determination.

## DETAILED DESCRIPTION OF THE PREFERRED EMBODIMENT

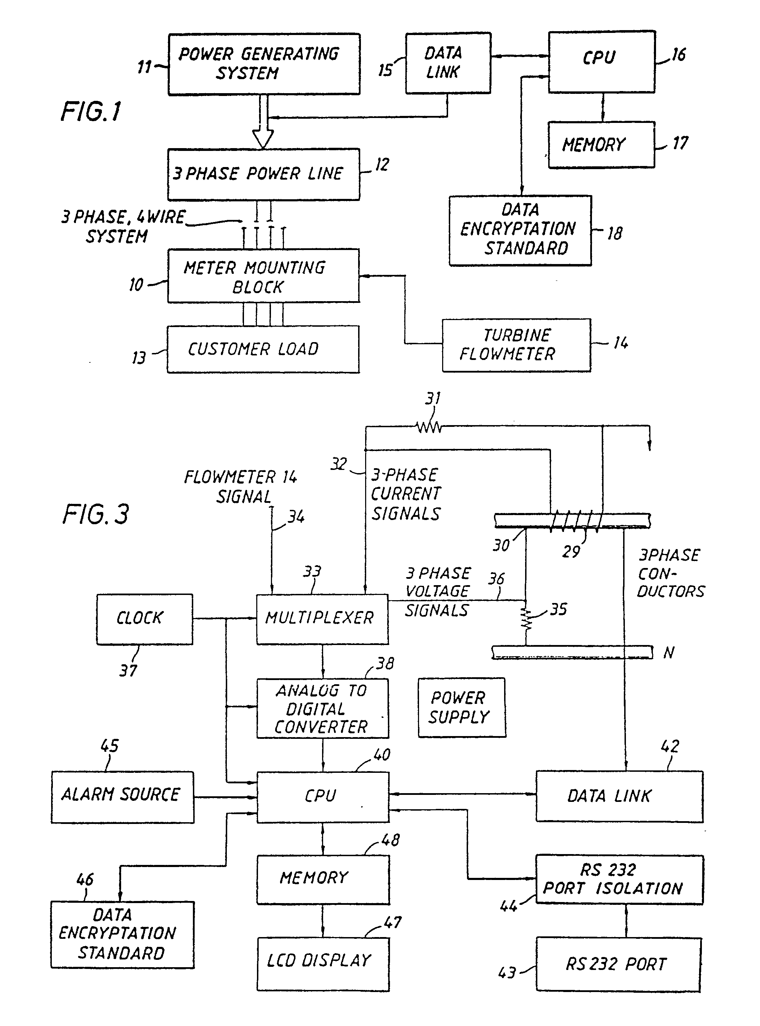

Going first to Fig. 1 of the drawings, a power distribution system is shown which will be described to provide the context for the present apparatus. The present apparatus is generally indicated by the numeral 10 and is installed at the meter mounting block shown in Fig. 1. To place this in the proper setting, a power generating system 11 is located elsewhere, providing an output which is ordinarily a three-phase four-wire output which is delivered to a power line 12. The electrical power can also be a three wire, three phase system or even a two wire residence system. The power line connects from the power generating system 11 to an individual customer who places a customer load 13 on the system. The present apparatus is intended for use with large and small customer loads and in that sense, the load can be simply a one-phase load for a typical 110 volt, 100 ampere service. Alternatively, it can be a larger residential installation or a commercial/industrial installation. The power line 12 typically will include step up and step down transformers. At the customer's location, the system typically includes a step down to 110, perhaps 220 and sometimes 440 VAC. Sometimes, the customer may require service as high as 13.8 KV. The customer is thus provided with either a three wire or a four-wire distribution at a selected voltage in typical circumstances. The present apparatus is not limited to precisely these voltages. Rather, higher voltages can be handled if the customer load requires such higher voltages. An important aspect of the present system is the ability to meter other flowing materials such as water and gas delivered to the customer, sewage outflow and the like. To this end, a turbine flowmeter 14 provides an output signal which is proportionate to flow volume of the gas or liquid metered at the customer's location. Accordingly, that data can be output and is treated in the same fashion as the electrical metering system. It is actually simpler data to handle in that no multiplication is required to convert measurements into wattage; in this particular instance, it is assumed simply that the output signal from the turbine flowmeter is proportional to the gas or liquid and a total is accumulated. But, special time tariffs can also be applied and the utility cost can then be determined.

The metering system 10 is installed for each individual customer. Hundreds, thousands and perhaps whole towns of customers can be serviced by wire from a single central location. This location incorporates a data link 15 which forms a signal for the customer to transmit information to or receive information from the utility data processing service. The data link 15 converts incoming and outgoing signals into high frequency pulses which are modulated onto the power line 12. By means of suitable high frequency filters, the signals can be picked off the power line and delivered to the customer. The data link provides two way communication for a CPU 16, and the CPU is equipped with a memory 17. For security purposes, a data encryption standard (DES) 18 is likewise incorporated. Its function is to provide secure data transfer whereby tariff and billing information is transferred to and from the customer. Each metered utility service can be separated for later separate billing if desired. This will be more apparent on consideration of Fig. 3 hereinafter.

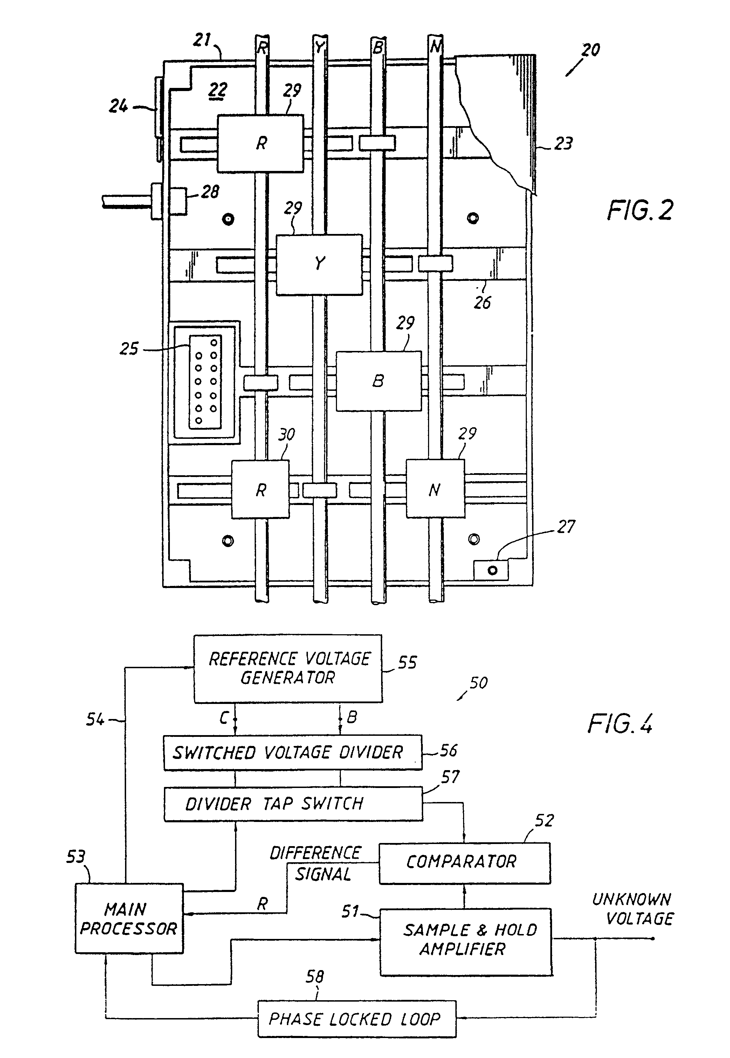

Going now to Fig. 2 of the drawings, the numeral 20 identifies a closure which clamps onto or around the wires making up the power distribution system to an individual customer. The wiring of course is sized to accommodate the demand of the customer. To this end, there are four conductors illustrated in Fig. 2 of the drawings. They can be labeled conveniently phases 1, 2 and 3. An alternate mode of labeling is to identify the three separate phases as red, yellow and blue in accordance with the European standard. There is a fourth conductor which is a neutral ground conductor. The four conductors are of conventional construction, and pass through this apparatus without requiring termination at terminal strips and the like. In other words, the four conductors are passed through the apparatus to be described, but typical connectors or terminals for the conductors are not needed. The four conductors are thus held in a spaced relationship from one another for safety sake, and they are installed with the conductor insulation intact other than small insulation perforations.

The meter box 20 has the top cover broken away to reveal the interior. It is formed of a four sided box 21 which is a surrounding wall with a closed back 22. It is strengthened at the corners with reinforcing posts on the interior. The box 20 is closed over by a lid 73. The lid has overhanging lips or flanges around the edges to assure that a hermetic seal is perfected so that the box can be installed exposed to the elements and rain will not enter the box and otherwise create a short. Ordinarily, the meter box 20 will not be exposed to rain. The lid 23 has been broken away and only a portion has been shown. The lid is fastened to the box by means of a suitable hinge 24. The hinge 24 supports the lid which supports a printed circuit board (PCB) on which all of the electronic components are mounted. The electronic components are preferably potted in epoxy to seal the components against inclement weather. The printed circuit board is connected with the various voltage and current pickups to be described through the plug 25 shown in Fig. 2 and is further connected to the LCD or LED display and infra-red couple on the face of the lid 23.

The interior of the box supports several partitions 26 which are reinforcing ribs across the open interior. They support various components and provide stiffening and reinforcing for the structure. The lid 23 is hinged to close in a shut position, and a key operated lock 27 is also included to lock the lid. This can be duplicated at multiple locations, for instance, the upper and lower corners. In addition, a hermetically sealed feedthru 28 is included to enable external conductors to communicate through the multi-lead plug 25 to components on the PCB. This can be used to bring in the signal from the turbine flowmeter 14 shown in Fig. 1. Accordingly, a signal conductor is supplied through the fitting 28 and connects through the plug 25. It is communicated to the PCB and the various components mounted on the PCB.

Consider the red phase first. The conductor is routed through the wall of the cabinet 20 and passes through a surrounding circular mounting block which encloses a coil 29 which forms a magnetic coupling to the conductor. This provides an output signal proportionate to current flow. If the current is nil, then the output signal corresponds. This is duplicated with current transformers 29 installed on all three power conductors. The several conductors are thus all monitored to measure the current flow through them. Incidentally, it should be noted that the neutral wire may or may not be included. Some electrical distribution systems use a wye distribution system while others use a delta system. Whatever the case, it is appropriate to show the incorporated neutral wire which can be omitted should the electrical distribution system not include the neutral.

The system also includes a block 30 which houses the voltage tap. That is, the instantaneous voltage of the red phase is sensed and measured with respect to neutral or across any two phases. The tap 30 normally pricks the insulation and contacts the wire. More will be noted regarding this hereinafter.

Going now to Fig. 3 of the drawings, one of the three-phase conductors is shown with a coil 29 encircling the conductor. The coil 29 has one side grounded and forms an output signal across a calibrated resistor 31. The resistor 31 serves as a reference standard. The voltage output is proportionate to the current flow, and is output on the conductor 32 to a multiplexer 33. One conductor 34 is from the turbine flowmeter is also shown. All current signals are supplied. Three-phase voltage signals are also supplied, all measured with respect to the neutral conductor. The tap at 30 connects with a suitable reference resistor 35. This is connected from one phase to neutral, and a suitable output conductor 36 is input to the multiplexer to provide the voltage signal. Three voltage signals are required to cover all phases. All input signals are provided for the multiplexer 33. The multiplexer is also provided with an input from a suitable clock 37. The multiplexed signals are output to an analog to digital converter 38. The ADC 38 digitizes the dynamic values. They are input to a CPU 40 for data conversion as will be described.

A power supply 41 is connected by means of a suitable transformer coil with one of the conductors to derive minimal power for operation of the system. The power required is in the range of just a few milliwatts, typically less than about 0.5 watts. It is not an excessively expensive device to operate in light of the benefits obtained from the system. Actual power consumption is about 25% of the normally required power for Ferraris wheel meters.

One or more of the conductors is used to deliver the high frequency, modulated data bursts which are delivered from the data link 15 shown in Fig. 1 and a corresponding data link 42 is also shown in Fig. 3. It furnishes data to the CPU from the CPU 16. For instance, tariff information can be delivered. Incremental power consumption can likewise be transferred on the data link. More will be noted concerning this hereinafter.

Other equipment shown in Fig. 3 includes an RS232 or RS423 port 43. This port is connected through an isolation circuit at 44. The isolation circuit protects the electronic circuitry in the meter, and prevents damage in the event of a short or excessive voltage applied to the terminals of the port 43. The port 43 preferably includes a keyed plug & socket combination enabling a two part infra-red couple to communicate into the closed, secure box 20. This offers protection in the event tampering wire attempted by placing the wrong voltages and currents on the input terminals at the port. Rather, electrical coupling is avoided while optical coupling by the cooperative parts of the system provides isolation against tampering in the form of voltage or current overload. A hand held mating fixture carried by a reader can be used to interrogate the memory to receive back a confirmation signal along with data, all coupled into and out of the CPU by infra-red data transfer, complete with terminal isolation. External tampering is thereby defeated.

An alarm system 45 is likewise included. The alarm system is a protective device which prevents tampering with the equipment by physical/electronic means. More will be noted regarding tampering by electronic means as for example transmission of erroneous data. The device further includes a corresponding data encryption standard 46 which responds to and encodes transmissions from the DES 18. More will be noted regarding this. An LCD or LED display 47 forms an output which is visible, the display being mounted on the lid or cover 23 previously mentioned. It is provided with a meter reading to be indicated to the customer. The meter reading is retrieved from the memory 48. The memory 48 is connected to the CPU and provides storage capacity for a large number of data words.

## SYSTEM PROTECTION FEATURES

An important factor is protection of the present apparatus from tampering. To this end, the port 43 connects with an isolation circuit 44. To limit the impact of sabotage, the isolation circuit 44 incorporates high voltage isolation so that only a signal level is communicated through it into the CPU 40. For instance, an infra-red coupled isolation circuit is often used.

The alarm source 45 is connected with the cabinet or housing of the apparatus. For instance, the cabinet or housing can be protected against intrusion or forced entry. It can also be connected with the lock system. All physical aspects of the structure can be protected because there is really no basic requirement for entry at any time other than of original installation and the rare occasion when service is required, months or years later. The device is preferably constructed so that the voltage transformers and current transformers shown in Fig. 2 provide outputs through the plug 25, and all the remaining circuitry mounted on the PCB within the lid can be removed and replaced. Easy disconnection is achieved by disconnection at the plug 25. The plug 25 disconnects the input lines 32, 34 and 36 shown in Fig. 3. These lines along with the connections for the power supply 41 and the data link 42 are the only lines that are physically interrupted on substitution of a new lid 23 for the box 20 along with the various electronic components mounted on the PCB. This makes servicing quite easy. Moreover, it enables the alarm source 45 to be sensitive to all types of mechanical intrusion.

The DES 46 is incorporated for prevention of data invasion. Potentially, one can sabotage the apparatus by means of inputting erroneous data. The data which is received from the CPU 16 is transmitted in a handshake sequence along the power lines 12 through the DES 18. Consider one example of operation. The DES 46 responds to a random number between whole numbers A and B of arbitrary value and converts it into a reply number. The conversion is dependent on the operation of the DES. The conversion accomplished in the DES 46 is in accordance with a relationship unknown at this end of the equipment. It is however in memory at the DES 18. Thus, a first random number between A and B is transmitted from the DES 18 to the DES 46, conversion is made, and the reply signal is transmitted back. When the reply signal is received back, confirmation is accomplished that the DES 46 is in fact the particular piece of equipment that was intended for connection in this data transfer. The DES 46 transmits back the encoded response; it is also possible to return a signal indicating tampering. The tampering may arise at the RS232 port 43, perhaps at the cabinet or as a result of the input of false or incorrect data. If desired, any sort of disturbance at the protective devices 44, 45 or 46 can be used to form an output signal transmitted through the data link 42. If desired, this can have the form of a general message that tampering has occurred, or it can include an encoded message specifying the nature of the tampering. Moreover, it can be enhanced with other data such as encoding the time of day, etc. This typically has the form of a prepared message stored in the memory 48 which encodes the requisite details to be transmitted through the data link to the CPU 16.

## IMPROVED ANALOG CONVERSION

In Fig. 4 of the drawings, an improved and alternate form of ADC is indicated at 50. There, an input from an unknown voltage source is provided to a sample and hold amplifier 51. It forms a particular measured output which is supplied to a comparator circuit 52. The comparator 52 forms a difference signal as a result of operation of the ADC 50 and delivers this to the main processor 53. The main processor 53 forms an output signal on the conductor 54 input to the reference voltage generator 55. It forms an output to a switched voltage divider 56. One end of the voltage divider typically will be at zero volts and the opposite end will be at a selected elevated voltage. The input voltage is thus divided into a number of increments or levels which are distributed at various points across the divider 56. The divider 56 connects with a set of divider switches 57 which output increments of the divider signal. The output from the switches 57 is a reconstruction of the input signal subject to control of the processor 53. The processor 53 controls the divider tap switches 57. Certain incremental voltages are switched on and certain are switched off to form an approximation of the input analog sample and hold signal. Roughly, the output of the reference voltage generator is given by the approximation of $V + 0.5$ sine$(360A/n) - 0.5R$. In the foregoing, A represents the sample number in the series of samples taken while n represents the total number of samples. Also, R represents the potential difference from the comparator 52. Also, V is the prior voltage approximation. The foregoing is accomplished during a hold interval under control of the sample and hold amplifier. A progressive approximation is made after the first data point approximation. Assume as an example that 1.0 volts is developed across the divider tap switches. If so, the approximation results is only a few millivolts resolution difference. This error is stored for the first approximation where $A = 1, 2, 3, ... n$. In the foregoing, as A progresses through 2, 3, ..., the approximation always is in the millivolt range. It is stored with sign, and when the several approximation errors are summed over a cycle of the sine wave, the average error is quite small.

The system shown in Fig. 4 incorporates stabilization through a phase lock loop (PLL) feedback path 58 which assures synchronization in taking the data points with the unknown input sine wave. Accordingly, the input sine wave is broken down into a multitude of evenly spaced sample points to assure that the accuracy is quite high and that the conversion is quite linear. The processor 53 is provided with the feedback signal from the PLL 58 that provides the appropriate gating signal for operation of the sample and hold amplifier 51 in timed fashion.

## DESCRIPTION OF THE CALCULATIONS

The present apparatus preferably utilizes the multiplexed ADC operation to provide the appropriate current and voltage inputs. Instantaneous power in watts is normally given by the product of PF(VI). By relationships believed to be well known, the power factor is typically determined by observing the zero crossing difference between voltage and current signal wave forms. This time difference translates into the angular shift between the two variables. From that, vector resolution yields resistive and reactive increments of the current. It is believed that instantaneous calculation is desirable because this takes into account the even small changes which occur in the harmonics of the sine waves and thereby integrates the energy involved in the harmonics of the two variable signals. Accordingly, instantaneous power is calculated. That calculation is dumped into a register in memory and stored incrementally. The memory preferably utilizes a EEPROM where appropriate calibration constants and other fixed data can be stored. The memory is larger than the data actually stored in it. Surplus memory capacity is included so that memory locations can be used until failure, at which time a particular register is shifted to another location in memory. The present system determines instantaneous values of power to be stored in an integrating register, with the data updated periodically as, for instance, typically once per second or less. In one embodiment of the present apparatus, the registers are updated after 48 cycles of the supply frequency at 50 hertz, the frequency prevailing in Europe. The same approach can be used where the line frequency is 60 hertz. Arbitrary updating of the registered power consumption at periods proceeds at what is realistically a very slow rate so that all values are permitted to settle and the words entered into memory can be checked for correct recordation.

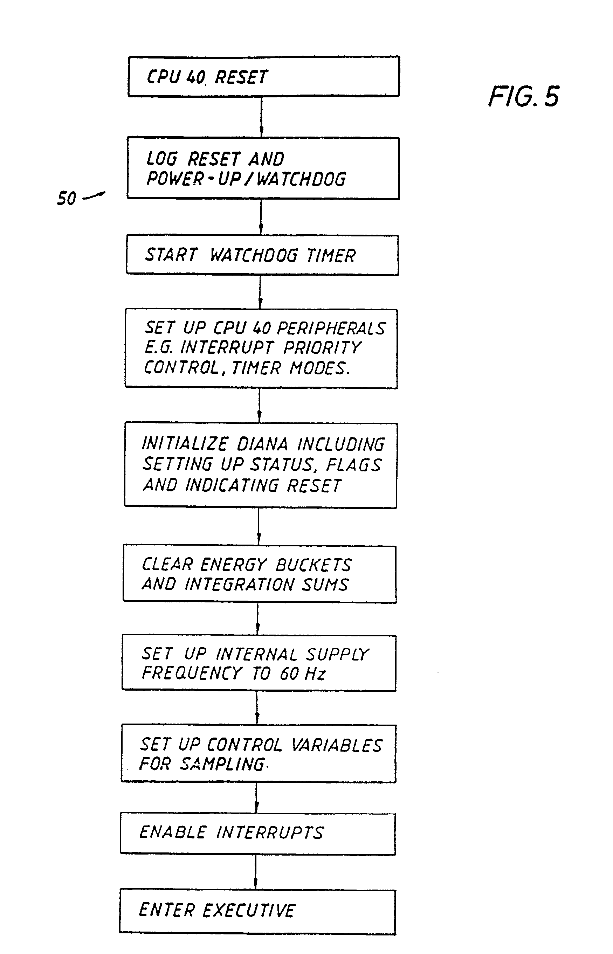

Attention is directed momentarily to Fig. 5 of the drawings where a reset routine 50 is illustrated. The CPU 40 is reset in the first step. That is, various values in the reset program and the registers are set to zero. The reset routine further includes the step of providing resets for the various alarm devices which are 44, 45 and 46 previously discussed. In other words, appropriate resets for those terminals are made so that they are in an armed and ready condition. After power up for these, the timer for the various alarm devices is started so that the time or date occurrence of any unwanted events can then be registered. The next step involves providing initial values to various components affiliated with the CPU such as the various priority interrupts, timers and the like. Initialization of values is then input indicative of status flags and appropriate resets. The various resets are input to a pseudocode control language for energy management known as DIANA. This pseudocode is preferably stored in the EEPROM memory (Nonvolatile memory or NVM). The various registers that are operated under control of this program are thus reset to the appropriate beginning values. Selected registers are registered as buckets to indicate that they are used for storing numbers having a different significance. The next step includes resetting all the energy buckets to zero and providing initial values for the integration sums. The process involves the phase lock loop system shown in Fig. 4; that involves a phase lock loop which is responsive to a particular frequency, namely 60 hertz in the western hemisphere and 50 hertz in Europe. The next step includes assigning variables for the sampling accomplished by the ADC shown in Fig. 4, which sampling is initiated repetitively for the various signal wave forms input through the multiplexer. Operation obviously involves different interrupts, for instance, when the data link transmits signals and the like. Various interrupts are properly enabled, and the program 50 terminates by preparing the next program 60 which is the executive program for execution.

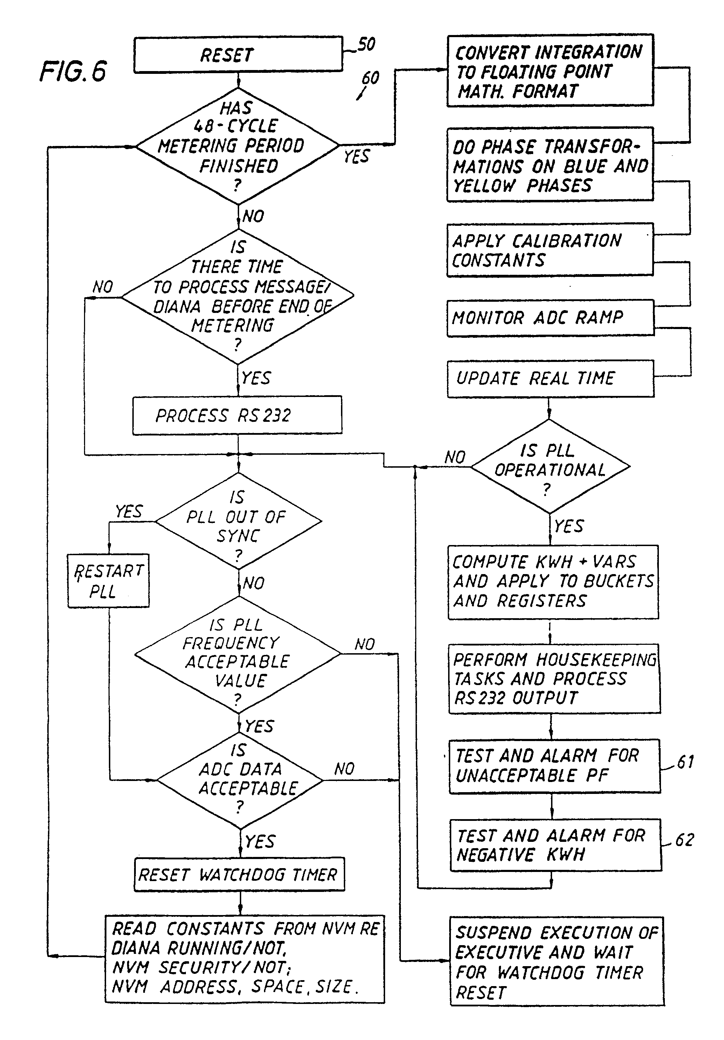

Going now to Fig. 6 of the drawings, a flow chart is illustrated which sets forth the executive routine. The calculations are normally performed over a specified interval which approaches about one second, the interval necessary for forty-eight cycles to pass. If that forty-eight cycle period has been completed and data has been measured and calculations made, the KWH and VARs are determined for one phase of the system and then is repeated for the remaining two phases of the system. The appropriate calibration constants are multiplied into the determinations, the ramp timing involved in the ADC is tested, verification with the system clock is made and the PLL is checked to determine if it is continuing its operation. Assuming that it is, the summations or integrations are completed for the energy (measured typically in KWH and obtained by integration over a timed interval) and the reactive values (VARs) are also determined. All of this data is transferred to the appropriate registers (including certain registers described as buckets for major data) and the appropriate output routines are then initiated. The routine shown in Fig. 6 periodically determines that the metering cycle of forty-eight cycles has not yet finished. While the data collection for forty-eight cycles is not complete, the executive routine proceeds to other housekeeping tasks. For instance, messages involving the transmission of data through the RS232 port or the data link might occur in this interval, and the interval is therefore measured to determine whether or not such messages can be processed. The PLL is checked to determine that it is in proper synchronization. The PLL frequency is checked to assure that the ADC conversion continues properly. System hardware values are checked so that all transducer outputs including all the measurements from the ADC are tested to determine if they are within anticipated ranges. The system also reads all the data in the non-volatile memory (the NVM) to check the memory system against aging of individual registers and to make confirmation tests of selected data accumulations therein.

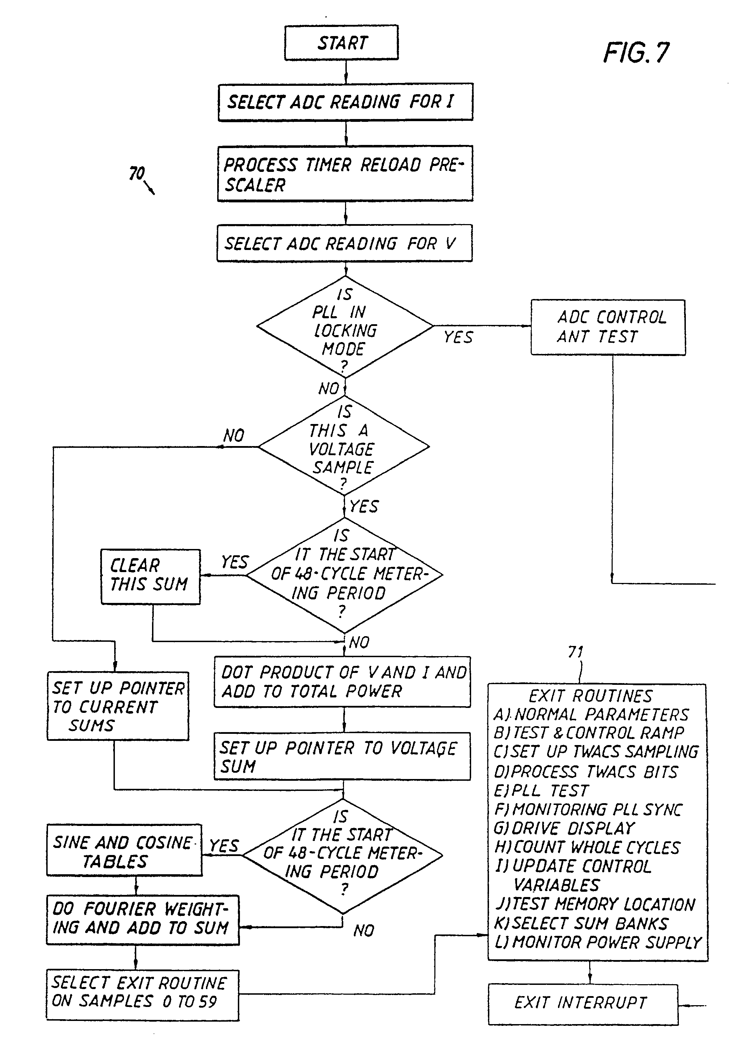

Fig. 7 shows a particular calculation routine which is quite successful for making the actual calculations. This routine is entered repetitively under instruction of the executive routine shown in Fig. 6. It is primarily a timer controlled sequence subject to interruption and involves taking sixty samples per cycle at equal intervals. This involves operational timed accuracy within a fraction of one microsecond. The periodic sampling carries forward small measures of error, but errors are substantially reduced to zero when integrated over a period of time. The routine can be readily performed on a single phase of the system (the red phase) to measure voltage and current. The system uses stored sine and cosine tables for reference purposes. Accordingly, current and voltage measurements obtained periodically enables formation of a vector dot product. During the first fifty-nine samples, and before the whole cycle is summed, the routine can exit to any of the indicated housekeeping duties, see step 71, items a) to 1).

Fig. 7 shows control of the voltage (and current) measurement sequence to assure that the cycle is broken down into sixty cycles. The ramp voltage is directed to a value of 128 and initiates a routine for measurement of voltage in the ADC. The ADC activity terminates by initiating the sequence shown in Fig. 7 again ad infinitum.

IMPORTANT TEST ROUTINES

Important test routines are included in the present system. One is shown at 61 in Fig. 6 which is a test and alarm routine for an unacceptable power factor. There are to types of power factor which may be unacceptable. One occurs where the power factor is derived from an inductive load which so shifts the PF from the desirable value of perhaps 0.95 down to some lower number, perhaps 0.80 or worse. That is a value which can be constantly monitored and which can be signaled. A low positive power factor is indicative of excessive inductive load, and some type of measurement is necessary, perhaps even resulting in the addition of a capacitive load to shift the PF back toward 1.00. While it is not common to encounter this problem in typical residential loads, certain small light industry installations may create such a load, and it may require correction. Thus, the PF is measured to assure that it does not materially drop below the acceptable value designated, typically in the range of about 0.85 or better. This may provide a signal that corrective measures need to be taken.

Another type of undesirable power factor occurs if there is some type of tampering with the system. One mode of tampering is to provide a momentary current flow through the meter which drives the meter backwards. So to speak, the wheel type meters can be driven backwards to decrement the stored total. It may normally occur for only a fraction of an instant at which time a power consuming motor is momentarily operated as a generator at which time it puts power back into the line. However, that condition will normally persist for only a few seconds. If that condition persists longer than that interval, it is a suggestion that the customer is either tampering with the meter with the creation of a false current flow at a wrong PF, or the customer is generating power which is put back into the line. The later event is not normally encountered except on a contract basis whereby customer generation results in a reduction of the cost of the utility. Accordingly, the step 61 tests for an unacceptable PF and particularly determines whether or not this unacceptable PF is sustained for some long interval such as more than one minute. If the customer is in a code generation mode, it may persist for hours or days on end, but in that instance, this can be fairly well identified in advance, there being very few utility customers who operate in this mode.

The step 62 tests for negative KWH. Ordinarily, KWH is a positive product. If the power factor is markedly shifted so that the current is in another quadrant, the PF will have a negative value. When this occurs, it is again an indication that perhaps an attempt has been made to decrement the power readings, and to this end an alarm condition is formed to indicate such currents. If desired, the peak KWH reading can be recorded and the value after decrementation can likewise be recorded to know the differential. That can be saved, and can constitute one of the several alarm conditions.

Another important test which is shown in Fig. 7 is located at step 71, and includes the testing of memory locations. Preferably, the memory that is used is much larger than normally required. As memory locations are used, they are first tested by inputting a test word, recycling that to assure that the test word is properly returned, and the location is verified. Ultimately, memory locations may fail and the test routine simply measures to determine success or failure of particular memory word locations. Another important test which is shown at step 71 includes the handling of the TWACS sampling and processing. The present apparatus can utilize a TWACS system instead of the data link which is shown in the drawing. Restated, the data link shown in the drawings can be a hard wired system utilizing the power distribution system as a conductive path. This normally operates by placing a high frequency signal on the wiring. Another approach is to utilize TWACS apparatus in a radio transmission system. There are many ways this can be accomplished. For one, a radio receiver can be used to obtain timing or synchronization signals by radio transmission, or they can be sent over the hardwire system. One approach is to synchronize the present apparatus with the signal transmitted by WWV. An alternate approach is to place appropriate timing signals on the hard wire system. Moreover, both can be used if an interlocking clock system is desired.

While the foregoing is directed to the preferred embodiment, the scope thereof is determined by the claims which follow.

**Claims**

1. A secure metering apparatus comprises:
   (a) a closed box having at least a pair of passages therethrough adapted to receive the conductors for customer electrical power distribution therethrough, said box fitting about the conductors, and said box incorporating enclosure means therewith;
   (b) electric current measuring means connected with said conductors for measuring current flow thereacross;
   (c) electric voltage measuring means connected with said conductors for measuring voltage therethrough substantially without intrusion into said conductors;
   (d) power measuring means connected to said current measuring means and voltage measuring means for forming an output signal indicative of measured power consumption; and

(e) two way transmission means connected with said power measuring means for forming secure communications to and from said power measuring means for forming a remote secure indication of power consumed by the customer.

2. The apparatus of Claim 1 including security means for protecting said box against intrusion.

3. The apparatus of Claim 1 including means for forming a transmitted signal indicative of physical tampering with said box, and including separate means for forming an indication of attempts to electronically tamper with said power measuring means.

4. The apparatus of Claim 3 including a remote means transmitting over said signal forming means system hand shake signals for secure data transmission and including means respond to encrypted hand shake signals within said enclosure means.

5. The apparatus of Claim 4 including means for detecting secure data transmissions received on said conductors.

6. The apparatus of Claim 1 wherein said current measuring means includes current transformers about said conductors, and said current measuring means forms output signals delivered through a mating plug and socket set, and including a removable and replaceable lid for said enclosure supporting circuit components thereon for operation of said power measuring means, thereby enabling removal and replacement of said power measuring means by disconnection of said plug and socket set within said enclosure means.

7. The apparatus of Claim 6 including a removable, hinge mounted lid, and lock means for securing said lid in a closed and sealed position on said enclosure.

8. The apparatus of Claim 7 including a printed circuit board mounted on said lid supporting said power measuring means.

9. A metering system for utility consumption by a customer comprising:
   (a) means for measuring electrical power instantaneously consumed by a customer wherein said measurements are obtained from electrical conductors connected with the customer;

(b) two way communication means connected to a said power measuring means for inputting thereto scale factors for said power measurements, said scale factors incorporating power pricing data; and
(c) means for forming an alarm signal indicative of (1) tampering including physical tampering with the system, (2) inputting of electronic data intended to tamper with the system, and (3) inputting of electrical power intended to damage the system.

10. The metering system of Claim 9 including means for summing an input signal proportional to customer consumption of fluid flow, and including means for multiplying summed consumption over an interval to obtain interval costs.

11. The system of Claim 9 including means for storing summed power consumption; and including means therewith for testing said storage means for accurate data entry.

12. The system of Claim 11 wherein said storage means comprises non volatile memory.

13. A metering system for measuring electrical power consumption by a customer delivered through conductors connected to that customer from a power distribution system, the metering system comprising:
   (a) current transformer means for deriving a current dependent signal from the current flowing in said conductors wherein said current signal is proportionate to current flow and includes the fundamental and harmonics of the current flow;
   (b) voltage input means for obtaining the voltage on the conductors input to the customer;
   (c) analog to digital converting (ADC) means provided with the signals from said current transformer means for forming a current dependent signal from the current flowing in said conductors wherein said signal is proportionate to current flow and includes the fundamental and harmonics of the current flow and also having an input from said voltage input means;
   (d) said ADC means including:
      (1) sample and hold input amplifier for receiving a variable to be measured and converted into digital form;
      (2) a comparator provided with two signals for comparison, said comparator forming a difference signal directed through a feedback loop for alteration of the two signals after operation of said comparator;

(e) a phase locked loop connected from said sample and hold amplifier forming a synchronized signal controlling operation of said comparator and amplifier to thereby initiate comparisons in a synchronized fashion wherein the different signal from said comparator is used in the next comparison and wherein said phase locked loop controls repetition of operation of slid ADC means; and

(f) circuit means connected to said ADC means for receiving digitized words representative of current and voltage measurements at timed intervals, said circuit means including a CPU having a memory therein for storing sine and cosine values of the phase angle of voltage and current to the customer, and wherein said circuit means determines instantaneous power as a function of digitized voltage measurements, digitized current measurements and the power factor dependent on the phase angle.

14. The apparatus of Claim 13 wherein said CPU is further provided with a scale factor representing cost of the power consumed by the customer and forms an incremental output indicative of electrical power consumption in KWH and cost thereof.

FIG.1

11 — POWER GENERATING SYSTEM

15 — DATA LINK

CPU — 16

MEMORY — 17

3 PHASE POWER LINE — 12

3 PHASE, 4 WIRE SYSTEM

10 — METER MOUNTING BLOCK

DATA ENCRYPTION STANDARD — 18

13 — CUSTOMER LOAD

TURBINE FLOWMETER — 14

FIG.3

FLOWMETER 14 SIGNAL

31

32 — 3-PHASE CURRENT SIGNALS

34

30

29

3 PHASE CONDUCTORS

33

CLOCK

MULTIPLEXER

3 PHASE VOLTAGE SIGNALS

36

35

37

ANALOG TO DIGITAL CONVERTER — 38

POWER SUPPLY

N

45

ALARM SOURCE

CPU — 40

DATA LINK — 42

46 — DATA ENCRYPTION STANDARD

MEMORY — 48

RS 232 PORT ISOLATION

44

LCD DISPLAY — 47

43 — RS 232 PORT

11

FIG. 2

FIG. 4

**FIG. 5**

50 —

```
CPU 40 RESET

LOG RESET AND
POWER-UP/WATCHDOG

START WATCHDOG TIMER

SET UP CPU 40 PERIPHERALS
E.G. INTERRUPT PRIORITY
CONTROL, TIMER MODES.

INITIALIZE DIANA INCLUDING
SETTING UP STATUS, FLAGS
AND INDICATING RESET

CLEAR ENERGY BUCKETS
AND INTEGRATION SUMS

SET UP INTERNAL SUPPLY
FREQUENCY TO 60 Hz

SET UP CONTROL VARIABLES
FOR SAMPLING.

ENABLE INTERRUPTS

ENTER EXECUTIVE
```

*FIG.6*

```
                  ┌─────────────────────┐ 50
                  │       RESET         │╱
                  └─────────┬───────────┘
                            │
                  ◇─────────────────────◇      60
                  │        HAS          │     ╱
        ┌─────────│    48-CYCLE         │─────────┐
        │         │ METERING PERIOD     │  YES    │
        │         │    FINISHED         │         │
        │         │        ?            │         │
        │         ◇─────────┬───────────◇         │
        │                   │ NO                  │
        │         ◇─────────────────────◇         │
        │         │        IS           │         │
        │         │   THERE TIME        │  NO      │
        │ ┌───────│ TO PROCESS MESSAGE/ │         │
        │ │       │ DIANA BEFORE END OF │         │
        │ │       │     METERING        │         │
        │ │       │        ?            │         │
        │ │       ◇─────────┬───────────◇         │
        │ │                 │ YES                 │
```

CONVERT INTEGRATION TO FLOATING POINT MATH. FORMAT

DO PHASE TRANSFORMATIONS ON BLUE AND YELLOW PHASES

APPLY CALIBRATION CONSTANTS

MONITOR ADC RAMP

UPDATE REAL TIME

PROCESS RS 232

IS PLL OPERATIONAL ? — NO

IS PLL OUT OF SYNC ? — YES → RESTART PLL

IS PLL FREQUENCY ACCEPTABLE VALUE ? — NO

COMPUTE KWH + VARS AND APPLY TO BUCKETS AND REGISTERS

IS ADC DATA ACCEPTABLE ? — NO

PERFORM HOUSEKEEPING TASKS AND PROCESS RS 232 OUTPUT

RESET WATCHDOG TIMER

TEST AND ALARM FOR UNACCEPTABLE PF — 61

READ CONSTANTS FROM NVM RE DIANA RUNNING/NOT, NVM SECURITY/NOT; NVM ADDRESS, SPACE, SIZE.

TEST AND ALARM FOR NEGATIVE KWH — 62

SUSPEND EXECUTION OF EXECUTIVE AND WAIT FOR WATCHDOG TIMER RESET

14

**FIG.7**

```
                    ┌──────────┐
                    │  START   │
                    └────┬─────┘
                         ▼
            ┌─────────────────────────────┐
            │ SELECT ADC READING FOR I    │
            └────────────┬────────────────┘
                         ▼
     70    ┌─────────────────────────────┐
           │ PROCESS TIMER RELOAD PRE-    │
           │ SCALER                       │
           └────────────┬────────────────┘
                         ▼
           ┌─────────────────────────────┐
           │ SELECT ADC READING FOR V    │
           └────────────┬────────────────┘
                         ▼
                     IS
                   PLL IN            ┌──────────────┐
                   LOCKING   ─YES─→  │ ADC CONTROL  │
                   MODE              │ ANT TEST     │
                   ?                 └──────────────┘
                    │NO
                    ▼
                     IS
         NO ←──── THIS A
                 VOLTAGE
                 SAMPLE
                    ?
                    │YES
                    ▼
  ┌──────────┐           IS
  │ CLEAR    │←─YES─  IT THE START
  │ THIS SUM │        OF 48-CYCLE METER-
  └────┬─────┘        ING PERIOD
       │                  ?
       │                  │NO
       ▼                  ▼
 ┌──────────────┐   ┌─────────────────────────────┐
 │ SET UP POINTER│  │ DOT PRODUCT OF V AND I AND  │
 │ TO CURRENT    │  │ ADD TO TOTAL POWER          │
 │ SUMS          │  └────────────┬────────────────┘
 └──────────────┘                ▼
                   ┌─────────────────────────────┐
                   │ SET UP POINTER TO VOLTAGE   │
                   │ SUM                         │
                   └────────────┬────────────────┘
                                ▼
 ┌──────────────┐           IS
 │ SINE AND     │←─YES─  IT THE START
 │ COSINE       │        OF 48-CYCLE METER-
 │ TABLES       │        ING PERIOD
 └────┬─────────┘            ?
      ▼                      │NO
 ┌──────────────┐
 │ DO FOURIER   │
 │ WEIGHTING AND│
 │ ADD TO SUM   │
 └────┬─────────┘
      ▼
 ┌──────────────┐
 │ SELECT EXIT  │
 │ ROUTINE ON   │
 │ SAMPLES 0 TO │
 │ 59           │
 └──────────────┘
```

71

```
┌─────────────────────────────┐
│ EXIT ROUTINES               │
│ A) NORMAL PARAMETERS        │
│ B) TEST & CONTROL RAMP      │
│ C) SET UP TWACS SAMPLING    │
│ D) PROCESS TWACS BITS       │
│ E) PLL TEST                 │
│ F) MONITORING PLL SYNC      │
│ G) DRIVE DISPLAY            │
│ H) COUNT WHOLE CYCLES       │
│ I) UPDATE CONTROL           │
│    VARIABLES                │
│ J) TEST MEMORY LOCATION     │
│ K) SELECT SUM BANKS         │
│ L) MONITOR POWER SUPPLY     │
└─────────────────────────────┘

┌─────────────────────────────┐
│ EXIT INTERRUPT              │
└─────────────────────────────┘
```

15

# EUROPEAN SEARCH REPORT

## EP 90 81 0250

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | Bulletin ASE/USC vol. 78, no. 23, 5 December 1987, CH pages 1442 - 1445; M.Brückner: "Ein elektronischer Haushaltelektrizitätszähler" * the whole document * | 1,2,12, 3-11,13-1 | G 01 R 21/00 G 01 R 21/133 |
| Y | EP-A-0 035 323 (SANGAMO WESTON) * claims 1-17; figures 1, 2 * | 3,6-9 | |
| Y | EP-A-0 014 038 (SOUTH EASTERN ELECTRICITY BOARD) * page 5, line 14 - page 8, line 13 * | 4,5,9 | |
| Y | ELEKTROTECHNISCHE ZEITSCHRIFT - ETZ. vol. 107, no. 16, August 1986, BERLIN DE pages 746 - 750; H.-W.Steinlein: "Maximumerfassung und Messdatenüber-tragung" * pages 748 - 750 * | 4,5,9-11, 14 | |
| Y | GB-A-2 076 976 (TOKYO SHIBAURA DENKI) * the whole document * | 13 | |

| | TECHNICAL FIELDS SEARCHED (Int. Cl.5) |
|---|---|
| | G 01 R 11/04 G 01 R 21/00 |

The present search report has been drawn up for all claims

| Place of search | Date of completion of search | Examiner |
|---|---|---|
| The Hague | 16 November 90 | LEMMERICH J |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document